(19) Europäisches Patentamt
European Patent Office
Office européen des brevets

(11) Publication number: 0 042 987 B1

(12) # EUROPEAN PATENT SPECIFICATION

(45) Date of publication of patent specification: 08.03.89

(51) Int. Cl.[4]: H 05 K 3/36, H 01 G 4/30, H 01 L 23/12, H 01 L 23/56, H 05 K 1/16

(21) Application number: 81104228.2

(22) Date of filing: 03.06.81

(54) **Electronic circuit chip carrier.**

(30) Priority: 30.06.80 US 164119

(43) Date of publication of application: 06.01.82 Bulletin 82/01

(45) Publication of the grant of the patent: 08.03.89 Bulletin 89/10

(84) Designated Contracting States: DE FR GB IT

(56) References cited:
DE-A-2 915 240
US-A-3 312 870
US-A-3 663 866
US-A-3 880 493

IBM TECHNICAL DISCLOSURE BULLETIN, vol. 22, no. 8A, January 1980, New York, US. C.W. HO et al.: "Fabrication of multiple LSI silicon chip modules", pages 3406-3409

IBM TECHNICAL DISCLOSURE BULLETIN, vol. 22, no 8A, January 1980, New York, US. C.W. HO et al.: "Multiple LSI silicon chip modules with power buses composed of laminated silicon sheets with metallized upper and lower surfaces", pages 3410-3414

(73) Proprietor: International Business Machines Corporation
Old Orchard Road
Armonk, N.Y. 10504 (US)

(72) Inventor: Bajorek, Christopher Henry
P.O.Box 243
Goldens Bridge New York 10526 (US)
Inventor: Chance, Dudley Augustus
21 Deepwood Drive
Danbury Connecticut (US)
Inventor: Ho, Chung Wen
49 Tanglewild Road
Chappaqua New York 10514 (US)
Inventor: Thompson, David Allen
Twin Lakes
South Salem New York 10590 (US)

(74) Representative: Gasslander, Sten
IBM Svenska AB Intellectual Property Department
S-163 92 Stockholm (SE)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 042 987 B1

Courier Press, Leamington Spa, England.

**Description**

In packaging of high speed switching "Large Scale Integration" (LSI) semiconductor circuit chips on a chip carrier, the fluctuation of power supply voltages as a function of switching current and the inductive coupling of voltages because of extremely high transients in switching currents can cause severe reliability problems. Certain special measures can be taken to prevent those effects from occurring. Previous solutions have included building capacitors into the carrier to provide decoupling of switching currents from the power supply. In addition, chip interconnections have been provided on the top surface of the chip carrier in the form of thin film conductors.

In accordance with this invention, different integrated electrical structures are employed to achieve capacitive and inductive decoupling of the chips in order to reduce problems associated with current surges caused by the rapid and sometimes simultaneous switching of the various myriad circuits contained within the extremely small but densely populated circuits of the chips carried upon the structures.

US—3,312,870 shows an electrical transmission system with parallel conductive plates having insulated outer surfaces, forming a laminated structure. The structure is stated to have a low reactance. In connection with Figs. 7 and 8, it is suggested that the circuit board for electronic computers can be built to incorporate parallel conductive plates with separate pins secured to either of the two sets of plates. There are two plates connected together which supply current in one direction between which is sandwiched a conductive plate for carrying current in the opposite direction. No suggestion is made of use of ceramic material laminated with thin metallic films. Conductive plates are oriented at right angles to the laminated structure of the substrate. Provision of vias about the periphery of the structure is not suggested nor is provision of conductive straps and pins. Connection of vias up to transverse straps also is not suggested.

US—3,663,866 describes a substrate for an array of microcircuit chips adjacent to connection pins which extend up from a stack of power conducting plates which are connected to the leads of the chips by means of wire wrap connections. However, the chips are located upon the lower section of the substrate and their leads extend up through the substrate for connection to terminals by means of wire wrap connections.

US—3,499,219 shows a stack of electrically conductive plates supporting an elongated conductive island within dielectric to form a coaxial transmission line within the plate.

In IBM Technical Disclosure Bulletin Vol. 22 No. 8A January 1980, a package for bipolar and FET chips is disclosed.

It comprises a module including a number of power buses composed of power plane sheets of silicon separated by layers of dielectric material.

The object of the present invention is to provide an integrated ceramic carrier for electronic circuit chips. The carrier includes power distribution circuits having high capacitance and low inductance and includes interconnections provided to the chips between the chip terminals and the power distribution elements. Thus power supply to high switching speed VSL1 chips on parallel power supply conductors may be smoothed.

The invention is defined in the appended claims 1 and 3; and how it can be carried into effect is hereinafter particularly described, with reference to the accompanying drawings, in which:—

Figure 1 is a perspective view of a lower portion of a chip carrier in accordance with one aspect of this invention;

Figure 2 is an exploded perspective view of a partially fabricated portion of the carrier of Figure 1;

Figure 3 is a plan view of the chip carrier of Figure 1 with a thin film ground plane applied upon the upper surface of the assembled structure taken on the line III—III of Figure 4;

Figure 4 is a broken sectional view of the complete vertical plate structure of Figures 1 and 3 taken generally on the line IV—IV of Figure 3;

Figure 5 is a perspective view of a modified ceramic substrate pattern shown in Figure 1 arranged from building blocks of ceramic material to form a pair of slots;

Figure 6 is a perspective view of another modified ceramic substrate pattern without slots;

Figure 7 is a perspective view which shows a modification of Figure 2;

Figure 8 is a sectional view of a portion of a chip carrier subassembly into which capacitive elements have been incorporated, taken on the line VIII—VIII of Figures 9 and 10;

Figure 9 is a sectional view of the substrate portion of Figure 8 taken on the line IX—IX of Figure 8;

Figure 10 is a plan view of the substrate portion of Figure 8;

Figure 11 is a plan view of the structure of Figure 10 after additional thin film wiring planes have been added on line XI—XI of Figure 12;

Figure 12 is a broken sectional view of the complete horizontal plate structure of Figures 8 to 11 taken generally on the line XII—XII of Figure 11;

Figure 13 is an end view of an oversimplified sketch of a sublaminate structure showing a modification of Figure 8;

Figure 14 is a similar view of a modification of Figure 13.

The portion of the chip carrier 9 shown in Figure 1 includes a laminated ceramic substrate 10 composed of a stack of horizontally oriented ceramic sheets 13 which are laminated together. Substrate 10 provides the bulk of the basic support for the structure. Several slots 12 are provided in the substrate 10 extending through from the top to the bottom of the stack of sheets 13. Inserted into each slot 12 is a set of vertically oriented sheets incorporating metallic capacitor plates. The metallic capacitor plates of the stacks 11 serve also the function of providing power supply connections between the upper and lower portions of carrier 9. Carrier 9 also includes signals and power vias and pins for external connections.

Each stack 11 is a laminated structure and is composed of numerous laminates 7 comprising ceramic substrates 8 (Figure 2) carrying alternating laminated layers of metallic capacitor and power planes 20 and ceramic or dielectric sheets 14. The laminates 7 in a capacitor stack 11 (Figure 1) are so oriented that they extend vertically when inserted within a slot 12 in substrate 10. The horizontal ceramic sheets 13 in substrate 10 include all about their periphery and between the slots 12 a matrix of vertically extending electrical conductors in the form of vias 17 composed of metal. The vias 17 serve as conductors for transmitting signals and power supply voltages to chips from sites not on the module. Vias 17 are interspersed with other vias connected to a reference voltage in a manner equivalent to annular coaxial transmission lines and vias 17 preferably have a fifty ohm characteristic impedance value.

A lower stack 25 of laminated horizontal sheets 15 located below substrate 10 and parallel to sheets 13 thereof is unslotted and is also constructed basically of ceramic material. Upon the uppermost sheet 15 of stack 25 is deposited an array of metallization straps 16 adapted electrically to interconnect lower tabs 21 of selected metallic power supplying, power planes 20 in laminates 7. Such interconnection is used for distribution of electrical power from the straps 16 up to the power planes 20 which connect electrically (as described in connection with Figure 4) to the chips. Straps 16 are also connected electrically to vias 24, beneath them in the stack 25. Vias 24 supply power from conventional connector pins 104 connected to metal pads 27 beneath the vertically extending vias 24 which project through the layers 15 from top to bottom. The connector pins 104 are preferably bonded by brazing to the metallic pads 27 in conventional fashion. Layers 15 also include redistribution metallization straps 18 co-operating with vias 24 for redistribution of signals and power to the grid of vias 17 above and of vias 24 below. The vias 17 and 24 are electrically connected where desired, when the structure is assembled by means of heat treatments which will be explained below. Alternative metal joining techniques obviously can be employed.

Metallic tabs 19 in selected positions on the tops of the power planes 20 interface (connect directly electrically and mechanically) with a ground plane 37 (Figures 3 and 4) or to selected slotted thin film conductors 95, 96, 98 and 99 upon the top surface 6 of substrate 10 and stacks 11. Dielectric 120 (Figure 3) between the ground plane 37 and the conductors 95, 96, 98 and 99 serve to separate the metallization of plane 37 and the conductors into separate terminals at different voltages to provide different electrical connections as explained in detail in connection with Figure 4 below.

A semiconductor electronic chip 180 with C-4 solder bonds 181 has its C-4 bonds supported upon pads or lands 189, 190, 191 and 192 which are thin films of metal supported upon a dielectric substrate layer 182 (glass, polyimide, glass ceramic or equivalent). Within layer 182 are located x and y direction wiring lines 121 for interconnection of the chips. Y interconnection line 93, connects through circular tab 51 (shown in phantom) on the lower face of the layer 182 and through via 42 (shown in phantom) down through dielectric sheets 13 of the stack 10. The signal via 42 is composed of a metal cylinder formed in layers of ceramic material. One of many parallel, capacitively coupled power planes 20 is shown with its upper projecting tabs 19 reaching up to strip conductors 95 and 98. Conductors 95 and 98 are portions of the same voltage plane (Figure 3). Conductors 95 and 98 contact other projecting tabs 19 extending from other selected parallel power planes 20 (not shown) for providing parallel electrical interconnection of the tabs 19. In similar manner, conductors 96 and 99 provide parallel interconnection of tabs 19 on other power planes 20, as does ground plane 37 between conductors 96 and 98. Thus electrical current may be supplied to the chip where required from the power planes 20 which are connected to external power supplies. The electrical connections to the C-4 bonds are provided by means of electrically conductive vias 185, 186, 187 and 188 from conductors 95 and 96, ground plane 37 and conductor 98, respectively, to pads or lands 189, 190, 191 and 192 which are actually connected to the individual C-4 bonds 181.

A process for the fabrication of the elements in Figure 1 is as follows:

1—The dielectric substrates 8 and sheets 14 in stacks 11, the dielectric ceramic sheets 13 in substrate 10 and the dielectric sheets 15 in horizontal stack 25 are formed of ceramic green sheet (uncured ceramic) material. Metal power planes 20 are applied to substrates 8 and sheets 14 which serve as capacitive electrodes as is explained further in greater detail in connection with Figure 2. Then the layers of laminates 7 are laminated together at about 75°C and 68.95 MPa (10,000 psi) pressure. Then the laminates 7 are cut to the desired size. Horizontal sheets 13 are laminated together to form substrate 10. Substrate 10 has slots 12 formed therethrough. Metal straps 16 and 18 are applied to the horizontal sheets 15 which are then laminated together to form stack 25. Substrate 10 and stack 25 have holes for vias punched in them, which are then filled with metallization.

2—The stacks 11 are assembled into the slots 12 in the substrate 10 and stack 25 added below, all in green form, and the assembly is pressed to laminate a second time.

3—The assembly is cut to size and sintered at a temperature from 900°C (glass ceramic) to 1560°C (alumina).

4—The top surface 6 of substrate 10 and the edges of stacks 11 are ground down to expose the tabs 19 for electrical connection.

5—A thin film multiple layer structure is deposited upon the top surface 6, to provide ground plane 37 and conductors 95, 96, 98 and 99, dielectric layer 182, thin film x and y metallization lines 121 and 93, engineering change pads and the like.

Alternatively, the structure can be fabricated as follows:

1A—Build up elements 10, 11 and 25 with appropriately metallized green sheets (as in 1 above) and laminate them separately. Cut and punch to form the desired shape.

2A—Sinter the laminated elements 10, 11 and 25 separately.

3A—Employ glass and brazing metals to join elements 10 and 11 together with element 25.

4A—Grind the top surface 6.

5A—Provide top surface metallization (TSM) such as wiring layers and engineering change layers by means of a thick film process, or deposit the thin film structure as in 5 above.

Modifications in the basic process are possible in order to achieve the same structure. A method of fabricating several ceramic-metallized laminates 7 of the capacitor stacks 11 is illustrated in Figure 2 in exploded form. Ceramic substrate 8 and sheets 14 serve as dielectric and the metallization of power planes 20 provides capacitance as well as conducting current to supply power to the chips. Because the metallization of power planes 20 is not interconnected with other such planes 20 directly within the stack 11, many deposition techniques are appropriate for depositing the metal upon the unfired green sheets 8 and 14 of ceramic material. Sheets 8 and 14 may be coated with metal layers 20 by means of spraying, screening, tape transfer or casting from a slurry, etc. Metallization 20 required some pattern definition so screening may be the preferred deposition method.

Figure 2 illustrates how to assemble laminates 7 from a large green sheet substrate 8 and green sheets 14. At least two sets of metallization, above and below the plane of the dotted line indicated by arrows 76 are made. That line indicates one of the planes along which the green sheets are to be cut to achieve capacitor stacks of Figure 1 subsequent to lamination. The sheets are cut prior to firing the ceramic material. It can be seen that on each green sheet substrate 8 or green sheet 14, there are at least two sets of metallization planes 20, and the graphic indication is that the green sheets are broken off at the bottom to illustrate the fact that many sets of narrow strips forming power planes 20 are laminated at a time prior to cutting and firing. In this way, manufacturing efficiency is achieved as a number of metallization patterns can be fabricated upon a large green sheet at one time. Then the stacks 11 of green sheets with metallization can be cut (horizontally as indicated by the dotted line) from uncut sheets 8 and 14 which have been properly aligned and laminated prior to firing. In other words many sets of power planes 20 can be fabricated simultaneously. Then they are processed as above. After cutting, the capacitor stacks 11 are inserted into the slots 12 in the stack 10, above the redistribution sheets 15 in stack 25. Then the sheets 13, the inserted capacitor stacks 11 and the bottom redistribution sheets 15 in stack 25 are laminated together to obtain a cohesive unit. Alternatively, the substrate 10, capacitor stacks 11 and the bottom stack 25 can be fired separately as described above in process step 2A and they are subsequently assembled together in a cohesive structure by a glassing technique for securing the capacitor stacks 11 in substrate 10 and by means of brazing of electrical connections of the metallization planes 20 to metallization straps 16 on top of the top sheet.

Figure 2 only shows three of the power planes 20 in a laminate 7, though there are many more, each on a sheet 14. There are three kinds of power plane 20 in which the tabs 19 and 21 are differently disposed. In the $V_2$ power plane 20 three tabs 19 on the upper edge which connect to the top surface metallurgy (TSM) ground plane 37 and a tab 21 on the lower edge to connect to one strap 16. The $V_1$ and $V_3$ power planes 20 have two tabs 19 on their upper edges which connect to conductors 96, 99 and 95, 98 (Figure 3), respectively. On the lower edges of the $V_1$ and $V_3$ power planes 20 are tabs 21 which connect to other straps 16.

The upper layer of metal TSM ground plane 37, and conductors 95, 96, 98 and 99 (Figure 3) on the top surface of the ceramic substrate 10 and the upper edges of stacks 11 is applied by plating, evaporation, or the like. This is a continuous thin metallic film which is slotted to form the conductors 95, 96, 98 and 99 and the tabs 51. The slots provide for electrical isolation. The ground plane 37 (Figure 4) connects by via 187 to the land 191 of metallization above, which connects to the chip, and is electrically connected below to vias 17 (Figure 1).

Metallic conductors 95, 96, 98 and 99 (Figure 3) in the plane of plane 37 labelled $V_1$ and $V_3$ contact some of the tabs 19 and are oriented to cross over the metallization of power planes 20 (shown in phantom) at right angles so that several power planes 20 are connected together electrically through their tabs 19, the conductors 95, 96, 98 and 99 acting as straps. Adjacent power planes 20 are connected through different tabs 19 to the different strap conductors and to the ground plane, the capactive connections between adjacent power planes 20 tending to reduce the voltage or inductive effect of electrical power surges from the chips connected to the chip carrier 9. The strap conductors have sufficient width and length to contact the tabs 19 which are intended to be contacted without difficulties caused by the deviation of the location of the tabs 19 within the ceramic structure from the specified location. Such deviation from specifications is caused by the uneven shrinkage of the ceramic structure after firing of the ceramic green sheets. For example, a tolerance such as 0.03 mm per cm measured from the centre of the substrate 10 can be employed as a rule of thumb.

Chip fan-out lines and pads for engineering change connections 92 (Figure 4) and other interconnection lines 121 are fabricated above the level of the ground plane 37. Also, above the level of ground plane 37 are dielectric layers 182 and vias 185, 186, 187, and 188 through layers 182 connected respectively to circular surface pads 189, 190, 191, and 192 providing power for C-4 connections of the chips to the chip carrier. Dielectric is composed of appropriate materials such as polyimide, glass, etc. A technique of applying the interconnections is described by Duffek in "Electroplating the New Generation of Minielectronic Devices", Plating *56*, 5, p. 505 (1969).

In place of the single laminated ceramic substrate 10 of Figure 1, a substrate 50 (Figure 5) may be constructed from individual blocks. Large area ceramic sheets 53 are laminated into layers and cut into rectangular patterns of varying dimensions as required. In this case two similar blocks 160 are cut to form the top and bottom members. Three similar blocks 150 are cut to form the intervening members and are shorter than the blocks 160. Slots 52 are formed between the blocks to receive capacitor stacks. The upper surfaces 56 of the blocks form a surface analogous to surface 6 in Figure 1.

The structure is placed into a mould and a capacitor stack (not shown) similar to stacks 11 in Figure 1 is inserted into each slot 52. Then the structure is laminated by means of application of pressure and heat to form a cohesive unit.

Figure 6 shows another alternative in which a substrate 60 similar to the substrate 50 (Figure 5) is composed of three laminated ceramic legs 170, which are fabricated from sheets 63 similarly to the blocks 150 and 160. Then between the three legs are inserted two capacitor stacks 61 composed of laminates 64 which are analogous to laminates 7 in Figure 1. Again, the elements can be assembled in a brick wall approach. The structure can be made to be very similar to the final construction of Figure 1 or the like. The separate elements will be joined during the firing to produce a single unified structure with the separate elements integrally joined together.

Figure 7 shows an alternative form of laminate 77 similar to the laminate 7. In this, the thick substrate 8 is replaced by a thin ceramic sheet 14. Then the remaining structure is assembled by screening metal planes onto the succeeding ceramic sheets 14 which are added to the structure after each succeeding sheet has been metallized. The sheets 14 can be about 0.02 mm to 0.1 mm thick.

A capacitor stack 11 may have 0.00254 cm thick insulating sheets 14 with a dielectric constant of 10. The amount of capacitance is:

$$C=8.85\times10^{-14}\ K\ A/t\ (nf)$$

where

K=dielectric constant

A=area of electrodes ($cm^2$)

t=dielectric thickness (cm)

$$C=10\times8.85\times10^{-14}\times\frac{9\ 0.6}{0.00254}=1.9\ nf$$

With 105 such insulating sheets, each with a 0.00127 cm thick conductive plane 20, the total capacitor has a thickness of approximately 0.4 cm and a total capacitance of 200 nf. Sharing the capacitance among ten chips, the capacitance per chip is 20 nf. Higher capacitances can be obtined by using glass ceramic materials instead of pure alumina or mixtures of ceramics with ferrelectric materials or other high dielectric constant oxides. Both can be made with dielectric constants greater than 10. Use of such materials makes it possible to match thermal expansivity of the substrate to that of the chips carried on the substrate. An optimum substrate can be obtained by using a high dielectric constant ceramic material in the capacitor stacks 11 and low dielectric constant ceramic materials elsewhere to reduce the flight time of electrical signals through the substrate.

Figures 8 to 12 illustrate an alternative ceramic chip carrier construction in accordance with this invention in which the capacitive planes are built into the substrate employing the green sheets oriented horizontally. The same arrangement of an integrated ceramic capacitor and signal vias is employed.

The substrate portion of a chip carrier 109 (Figure 12) is made of a number of sublaminates 38, the uppermost one of which is shown in greater detail in Figure 8.

Sublaminate 38 (Figure 8) is fabricated from a blank thick green sheet 30 of ceramic dielectric on which is deposited a layer of metal to form a capacitor plane 31. The plane 31 has apertures 44 formed therein to provide for isolation of the plane 31 from selected vias passing therethrough in the assembled sublaminate. A ceramic layer 32 of 0.00254 cm thickness is applied on top of the plane 31 and fills the apertures 44. No distinction is made in the drawing between sheet 30 and layer 32, as, after lamination and firing, the layers merge. A layer of metal is deposited on the layer 32 to form a capacitor plane 33 in which there are apertures 34 for isolation of the plane 33 from other selected vias passing therethrough in the assembled sublaminate. A ceramic layer 29 similar to layer 32 is applied on top of the plane 33 and fills the apertures 34. A layer of metal is deposited on the layer 32 to form a capacitor plane 35 in which there are apertures 43 for isolation of the plane 35 from other such selected vias. A ceramic layer 36 similar to layer 32 is applied on top of plane 35 and fills the apertures 43.

Metal is applied to ceramic surfaces by screening or spraying a ceramic slurry, or laminating a green ceramic sheet or by applying a tape transfer. The process is repeated several times to form a subassembly which is thick enough (about 0.0254 cm) to be punched with a matrix of holes which are filled with metal paste by conventional means to form power vias 41, 81, 82, 83, 84, 85 and 86 and signal vias 40. Vias 41 and 83 connect to plane 33. Vias 81, 84 and 86 connect to plane 31 and vias 82 and 85 connect to the plane 35.

A metal ground plane 87 (Figure 10) is deposited on the top of layer 36 with annular apertures 178 to form circular tabs 88 to contact signal vias 40 (Figure 9), and with rectangular slots 71, 72, 73, 74, 75, 70, 78 and 79 (Figure 10) to form conductive straps 65, 66, 67, 68 and 69. The power vias 81, 84 and 86 connect to $V_3$ straps 65, 67 and 69, respectively. The power vias 82 and 85 connect to $V_1$ straps 66 and 68, respectively, and the power vias 41 connect to ground plane 87.

Several sublaminates 38 are stacked one upon another (Figure 12), so that many capacitor planes 31, 33 and 35 are connected in an array to respective conductive straps 65, 66, 67, 68 and 69 and the ground plane 87. The lowermost sublaminate 38 may be mounted on a stack similar to the stack 25 (Figure 1) with connections made through straps 16 and 18 and vias 24 to pins 104. Alternatively, as shown in Figure 12, the lowermost sublaminate 38 has further metallised layer including straps, such as straps 111, 112, 113 and 114, to which vias, such as vias 81, 82, 83 and 84, are connected. A further layer 138 of ceramic dielectric covers the metallised layer and contains metal filled via holes 124, by which straps are connected to pins 134.

Above the topmost sublaminate is a dielectric substrate layer 182, similar to that in Figure 4 and upon which a chip 180 with C-4 solder bonds 181 supported upon lands 189, 190, 191 and 192 connected by vias 185, 186, 187 and 188 to straps 65, 66, ground plane 87 and strap 67.

Each group of power vias 81, 84 and 86, and vias 82 and 85 and vias 41 and 83 is connected to a plurality of capacitor planes 31, 35 and 33, respectively. These groups of vias are connected to supply voltages of $V_3$, $V_1$ and $V_2$, respectively, to the chip 180.

A dotted line pattern 39 (Figures 9, 10) indicates the region which is located directly below a chip site. The line 39 encompasses all the vias with connections to the straps 65, 66, 67, 68 and 69 (Figure 10). The tabs 88, for connection of signals to the chip fanout, are connected to vias 40 (Figure 9) which are surrounded by insulation in the apertures 34 to insulate the vias from the capacitor planes 33 connected to the ground plane 87.

The top ground plane 87, which is a screened metal paste layer, serves the purpose of providing an additional metal layer which enhances the capacitance of the structure as well as facilitating electrical testing for short circuits, open circuits, and for enlarging the via dimension tolerances so that multiple assemblies can be aligned and laminated together to form the ceramic substrate subassembly.

The capacitor planes 31, 33 and 35 are produced from a typical metal paste layer. Within the lines 39 directly below a chip site, each row of apertures 34 filled with insulation (about 0.033 cm) is designed to let a different power supply voltage pass through with adequate clearance for the mechanical punch and fabrication tolerances. The rows of vias 41 contact the particular metal layers which form the planes 33 (Figure 9). Via holes are punched and filled after a subassembly is fabricated as described above. Vias 40 in dielectric filled apertures 34 outside are employed for the signals and for the return current, being made in the same way.

As can be seen, by superimposing Figure 10 upon Figure 9, the rows of power vias for the same power supply are connected together to ensure good electrical contact and to avoid problems of poor connection caused by misalignment. The apertures in the metal paste provide the needed clearance of the vias and straps from each other.

As shown in Figure 12, similarly to the first structure of Figures 1 to 4, the top surface of the substrate is metallized with a layer including straps 189 to 192 after firing in a subsequent step for deposited thin film layers. The pattern of metallization on top is shown in Figure 11.

For a 10 cm by 10 cm substrate carrying about 100 chips, a preliminary design indicates that an area of about 5.8 $cm^2$ must be excluded from the surface area useful for producing capacitance because of the disk shaped via openings in the sheets of metal. Accordingly, the total capacitance for 20 subassemblies of ceramic capacitors using insulating layers 0.0025 cm thick with a dielectric constant of ten and thirty-two dielectric layers per subassembly in the substrate is as follows:

$$C=20\times 8.85\times 10^{-14}\times 10\times \frac{(100-5.8)\times 3.2}{0.00254}=2100 \text{ nf.}$$

Therefore, each chip shares the capacitance with 21 nf per chip in an approximately 0.5 cm thick substrate. In both the vertical and horizontal structural embodiments, the chip carriers can be used as either single or multiple chip carriers.

The lands 65, 66, 67 and 68 and ground plane 87 (Figure 10) form the upper surface of one of the sublaminates 38, each of which includes a number of parallel layers of metallization forming capacitor planes 31, 33 and 35 with vias passing therethrough (Figure 12). Numerous sublaminates 38 are stacked upon the modified lowest sublaminate 38 with vias truncated so that there are no vias extending to the lowest surface 130 of the ceramic. In the assembly, there are pins 134 connected to the bases of vias, with numerous pins arranged in a matrix represented by the two pins shown. Thus, considerable capacitance is achieved by stacking the horizontal capacitor planes which are connected to the vias to provide regulation of the current surges (di/dt) which would tend to modulate the voltages to the chips causing introduction of erroneous signals into the chip.

Figure 13 shows a modified construction 128 for a sublaminate similar to sublaminate 38 of Figure 8. A thick ceramic base layer 140 of uncured ceramic green sheet material is used as a support for a laminated structure of thin metallic layers 131, 133, 135, and 137 which are analogous to layers 31, 33, 35 and 87 in Figure 8, and ceramic layers 132, 129 and 136 which are analogous to layers 32, 29 and 36 in Figure 8. The metallic layers are applied by screening on thin layers upon the layer below.

The construction 128 can be fabricated by means of a different process starting with the thick sheet layer 140 and screening on the metallic paste for layers 131, 133, 135 and 137 as above but applying three thin green sheets 132, 129 and 136 which have been screened independently either in parallel steps or serially as the sheets lie in place. The thick layer 140 provides rigidity. The structure is laminated in any event. After lamination, the layers can be punched to provide holes into which metallic paste can be inserted to form vias.

Figure 14 shows an alternative structure 148 for a sublaminate wherein layers 230, 232, 234 and 236 are all thin layers of ceramic material preferably in the form of thin green sheets. Four layers of metal paste 231, 233, 235 and 237 are screened upon the thin sheets of ceramic material. Different $V_1$, $V_2$, and $V_3$ patterns are screened on in a rotating series as usual.

**Claims**

1. Electronic chip carrier (9) including a planar substrate (10) having a first and a second surface opposite to each other and a plurality of electrical conductor means within the substrate to provide electrical interconnection between said opposed surfaces of the substrate (10) from one (6) of which connections are made to at least one chip, the substrate further having embedded between its surfaces elongated stacked capacitive elements (11) composed of a plurality of thin electrically conductive sheets (20) and a plurality of thin layers (14) of dielectric material laminated with each other, respective conductive sheets in the stacks constituting said conductor means, characterized in that adjacent conductive sheets (20) extend in the direction of the opposed surfaces of the substrate at substantially right angles with respect to said opposed surfaces, said sheets having portions (19, 21) at edge surfaces thereof facing outwardly towards said opposed surfaces and reaching said surfaces at different positions with respect to the longitudinal direction of said stacked capacitive elements, said portions thereby being exposed for electrical connection.

2. Chip carrier according to claim 1, wherein the exposed portions of groups of conductive sheets are interconnected by conductor strips on the substrate which are transverse with respect to the longitudinal direction of said stacked capacitive elements.

3. Electronic chip carrier including a planar substrate (29, 30, 32, 36) having a first and a second surface opposite to each other and a plurality of electrical conductor means within the substrate to provide electrical interconnection between said opposed surfaces of the substrate (29, 30, 32, 36) from one of which connections are made to at least one chip, the substrate further having embedded between its surfaces elongated stacked capacitive elements composed of a plurality of thin electrically conductive sheets (31, 33, 35) and a plurality of thin layers (29, 30, 32, 36) of dielectric material laminated with each other, characterized in that adjacent conductive sheets (31, 33, 35) extend parallel to said opposed surfaces of the substrate, there being elongated electrical conductors (81, 82, 83, 84; Figure 8) extending through the stacked capacitive elements in contact with selected conductive sheets and isolated from others, said elongated electrical conductors providing electrical connection at the opposed surfaces of the substrate at different positions thereof.

**Patentansprüche**

1. Elektronischer Chipträger (9) mit einem planaren Substrat (10), welches einander gegenüberliegend eine erste und eine zweite Oberfläche aufweist, und einer Anzahl von elektrischen Leitermitteln im Substrat zur Schaffung einer elektrischen Verbundung zwischen den einander gegenüberliegenden Oberflächen des Substrats (10), wobei von einer (6) derselben Verbindungen zu wenigstens einem Chip hergestellt sind, wobei das Substrat ferner zwischen seinen Oberflächen eingebettet langgestreckte geschichtete kapazitive Elemente (11) aufweist, die aus einer Anzahl von dünnen elektrisch leitenden Folien (20) und einer Anzahl von dünnen Schichten (14) aus dielektrischem Material, die miteinander laminiert sind, aufgebaut sind, wobei die jeweiligen leitenden Folien in den Stapeln die Leitermittel bilden, dadurch gekennzeichnet, daß benachbarte leitende Folien (20) sich in der Richtung der entgegengesetzten Oberflächen des Substrats unter im wesentlichen rechtem Winkel in Bezug auf diese entgegengesetzten Oberflächen erstrecken, wobei die Folien Abschnitte (19, 21) in ihren Randflächen aufweisen, die nach außen zu den gegenüberliegenden Oberflächen weisen und diese Oberflächen an unterschiedlichen Stellen in Bezug auf die Längsrichtung der geschichteten kapazitiven Elemente erreichen, wodurch diese Abschnitte für einen elektrischen Anschluß freiliegen.

2. Chipträger nach Anspruch 1, bei welchem die freiliegenden Abschnitte von Gruppen leitfähiger Folien miteinander durch Leiterstreifen auf dem Substrat verbunden sind, die quer zur Längsrichtung der geschichteten kapazitiven Elemente sind.

3. Elektronischer Chipträger mit einem planaren Substrat (29, 30, 32, 36), welches einander gegenüberliegend eine erste und eine zweite Oberfläche aufweist, und einer Anzahl von elektrischen Leitermitteln im Substrat zur Schaffung einer elektrischen Verbindung zwischen den einander gegenüberliegenden Oberflächen des Substrats (29, 30, 32, 36), wobei von einer derselben Verbindungen zu wenigstens einem Chip hergestellt sind, wobei das Substrat ferner zwischen seinen Oberflächen eingebettet langgestreckte geschichtete kapazitive Elemente aufweist, die aus einer Anzahl von dünnen elektrisch leitenden Folien (31, 33, 35) und einer Anzahl von dünnen Schichten (29, 30, 32, 36) aus dielektrischem Material, die miteinander laminiert sind, aufgebaut sind, dadurch gekennzeichnet, daß benachbarte leitfähige Folien (31, 33, 35) sich parallel zu den einander gegenüberliegenden Oberflächen des Substrats erstrecken, langgestreckte elektrische Leiter (81, 82, 83, 84; Fig. 8), die sich durch die geschichteten kapazitiven Elemente in Kontakt mit ausgewählten leitfähigen Folien und getrennt voneinander erstrecken, vorhanden sind, wobei die langgestreckten elektrischen Leiter eine elektrische Verbindung an den gegenüberliegenden Oberflächen des Substrats an unterschiedlichen Stellen derselben schaffen.

**Revendications**

1. Support (9) pour microplaquettes électroniques, comportant un substrat plan (10) possédant des première et seconde surfaces situées à l'opposé l'une de l'autre et une pluralité de moyens en forme de conducteurs électriques situés dans le substrat de manière à établir une interconnexion électrique entre lesdites surfaces opposées du substrat (10), à partir de l'une (6) desquelles des connexions sont établies avec au moins une microplaquette, le substrat comportant en outre, à l'état inséré entre ses surfaces, des éléments capacitifs allongés empilés (11) constitués par une pluralité de feuilles minces électriquement conductrices (20) et par une pluralité de couches minces (14) d'un matériau diélectrique, superposées les unes aux autres selon une disposition stratifiée, des feuilles conductrices respectives dans les piles constituant lesdits moyens en forme de conducteurs, caractérisé en ce que des feuilles conductrices (20) adjacentes s'étendent dans la direction des surfaces opposées du substrat en étant sensiblement perpendiculaires auxdites surfaces opposées, lesdites feuilles comportant des parties (19, 21) situées au niveau de leurs surfaces marginales et tournées vers l'extérieur en direction desdites surfaces opposées et atteignant lesdites surfaces dans différentes positions par rapport à la direction longitudinale desdits éléments capacitifs empilés, lesdites parties étant de ce fait à nu pour un raccordement électrique.

2. Support pour microplaquettes selon la revendication 1, dans lequel les parties à nu de groupes de feuilles conductrices sont interconnectées par des bandes conductrices situées sur le substrat et s'étendant transversalement par rapport à la direction longitudinale desdits éléments capacitifs empilés.

3. Support pour microplaquettes électroniques, incluant un substrat plat (29, 30, 32, 36) possédant des première et seconde surfaces situées à l'opposé l'une de l'autre et une pluralité de moyens en forme de conducteurs électriques situés dans le substrat de manière à établir l'interconnexion électrique entre lesdites surfaces opposées du substrat (29, 30, 32, 36), à partir de l'une desquelles des connexions sont établies avec au moins une microplaquette, le substrat comportant en outre, à l'état inséré entre ses surfaces, des éléments capacitifs allongés empilés constitués par une pluralité de feuilles minces électriquement conductrices (31, 33, 35) et par une pluralité de couches minces (29, 30, 32, 36) réalisées en un matériau diélectrique, superposées les unes aux autres selon une disposition stratifiée, caractérisé en ce que des feuilles conductrices (31, 33, 35) adjacentes s'étendent parallèlement auxdites surfaces opposées du substrat, les conducteurs électriques allongés (81, 82, 83, 84; figure 8) s'étendant à travers les éléments capacitifs empilés en étant en contact avec des feuilles conductrices sélectionnées et en étant isolés par rapport à d'autres feuilles et lesdits conducteurs électriques allongés établissant une connexion électrique au niveau des surfaces opposées du substrat, en différents points de ces dernières.

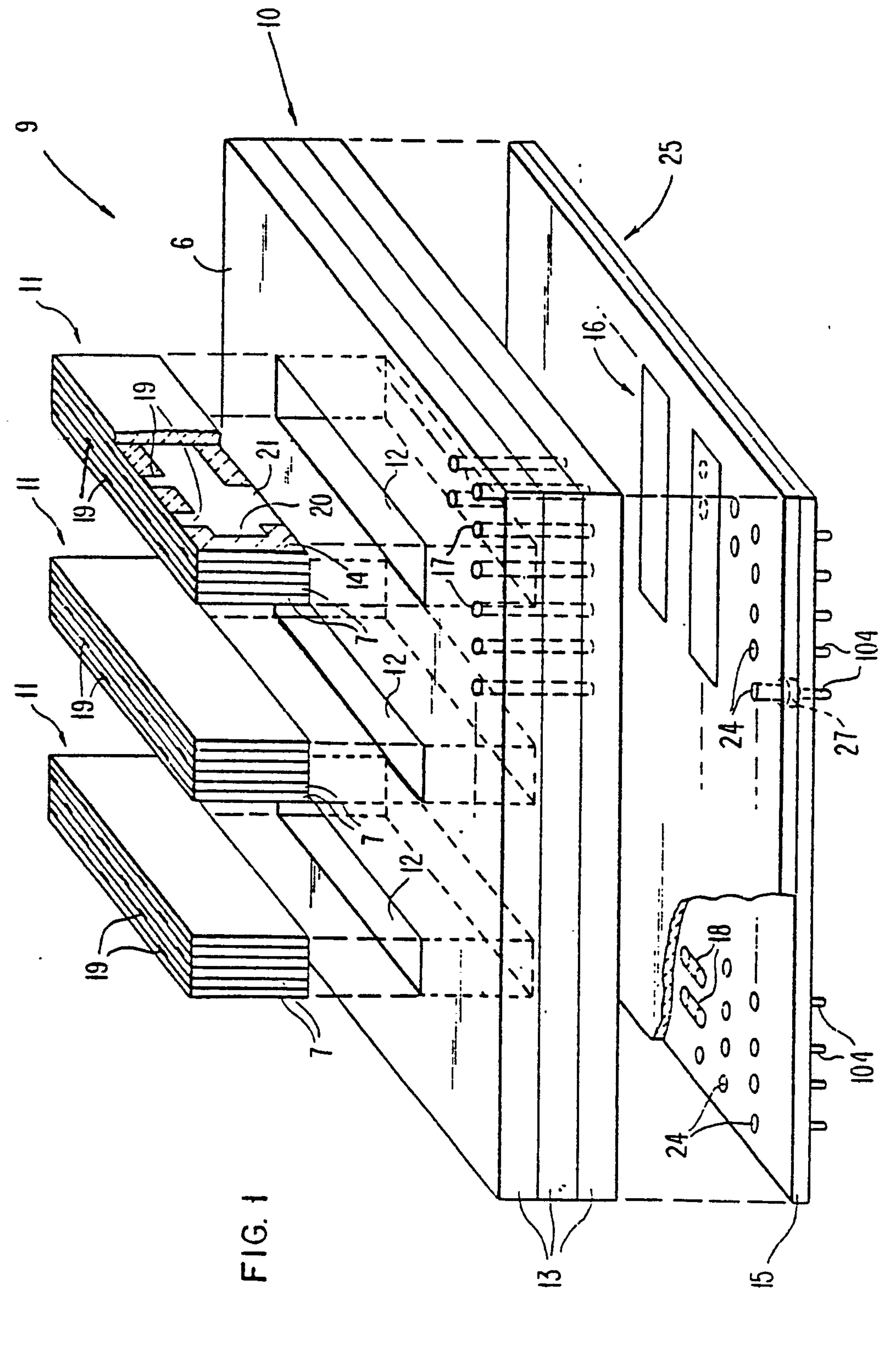


FIG. 1

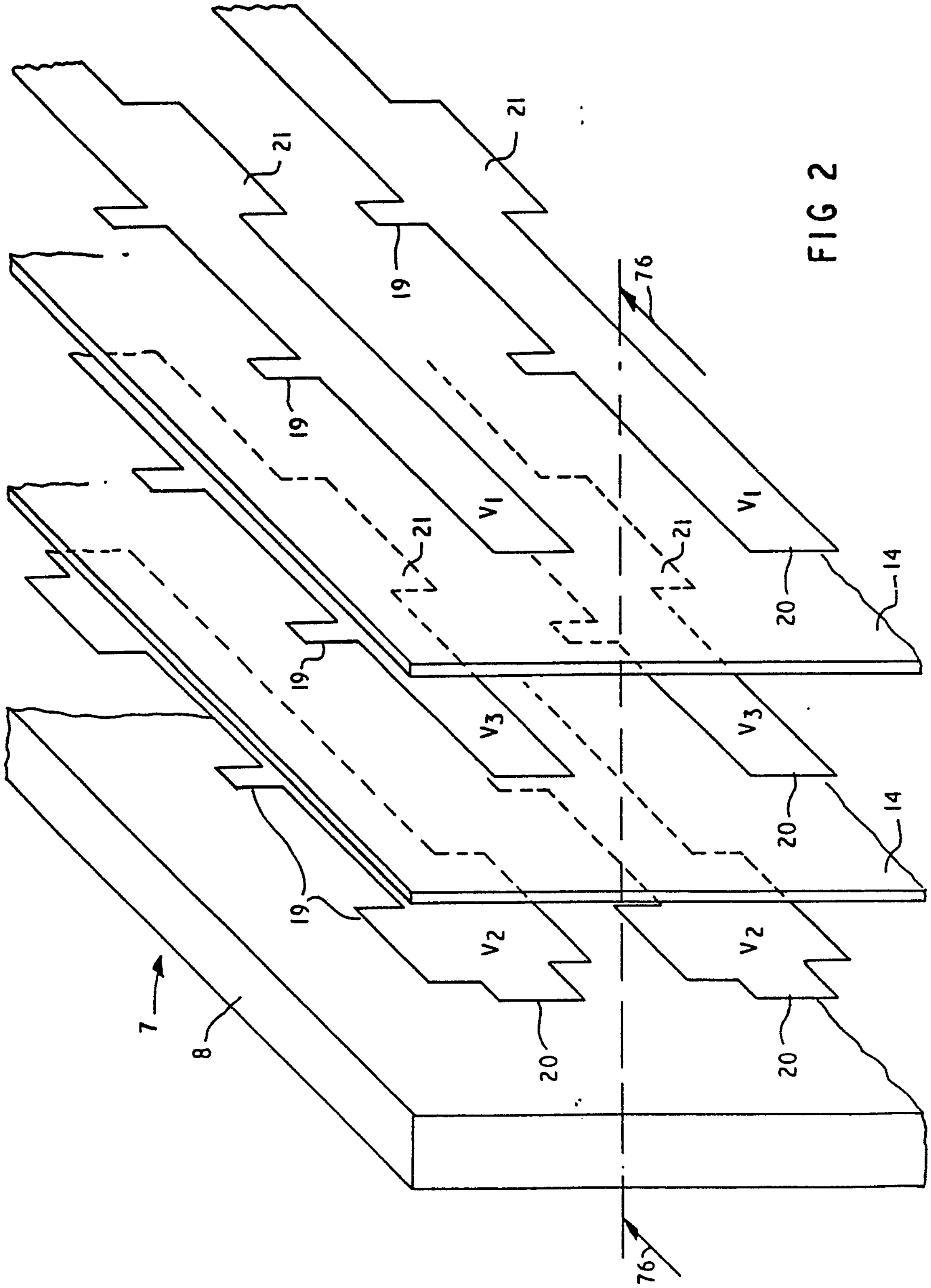


FIG 2

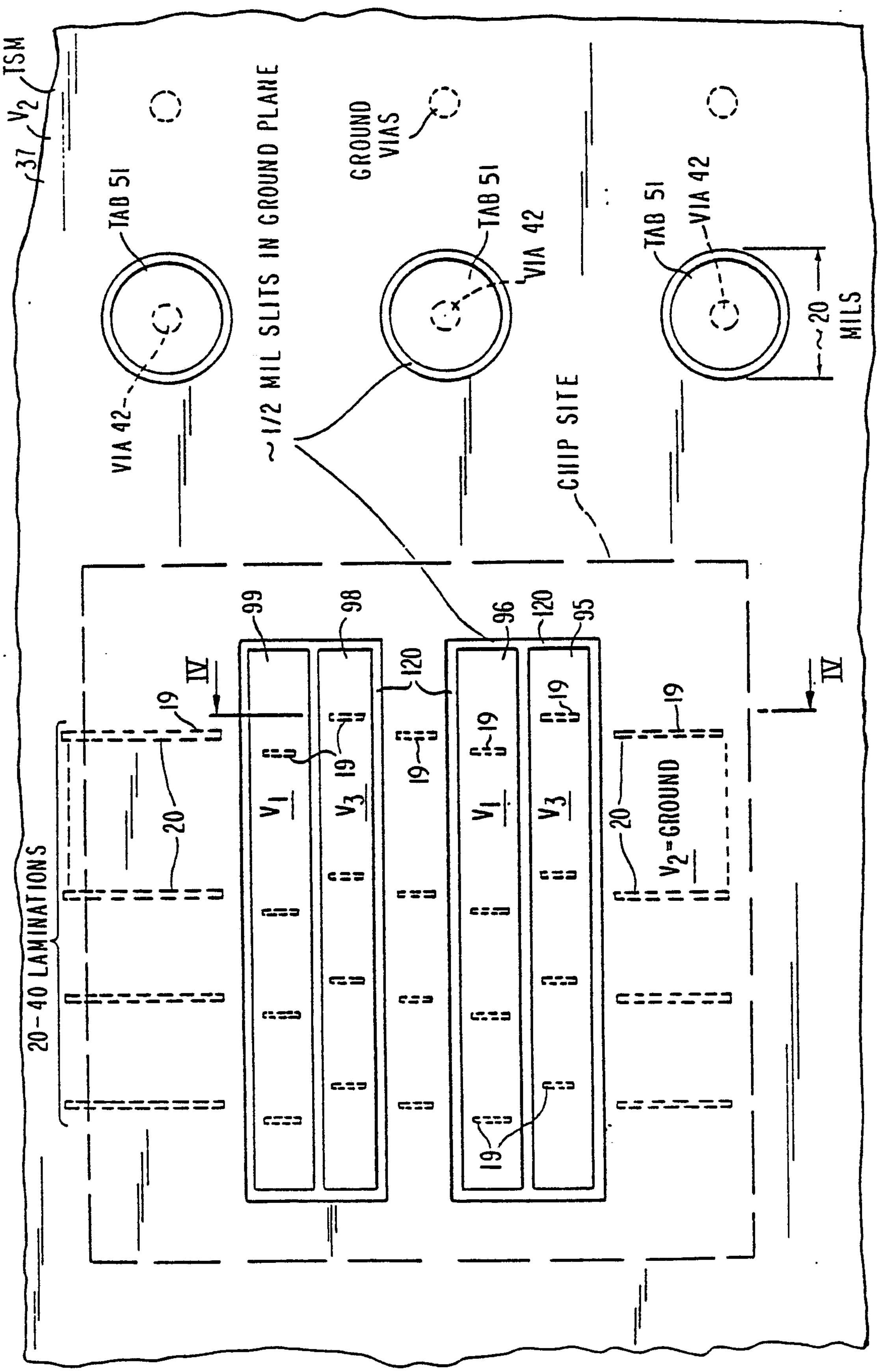
TSM
$V_2$
37
TAB 51
VIA 42
GROUND VIAS
~1/2 MIL SLITS IN GROUND PLANE
CHIP SITE
~20 MILS
99
98
96
120
95
IV
19
20
$V_1$
$V_3$
$V_2$=GROUND
20-40 LAMINATIONS

FIG. 3

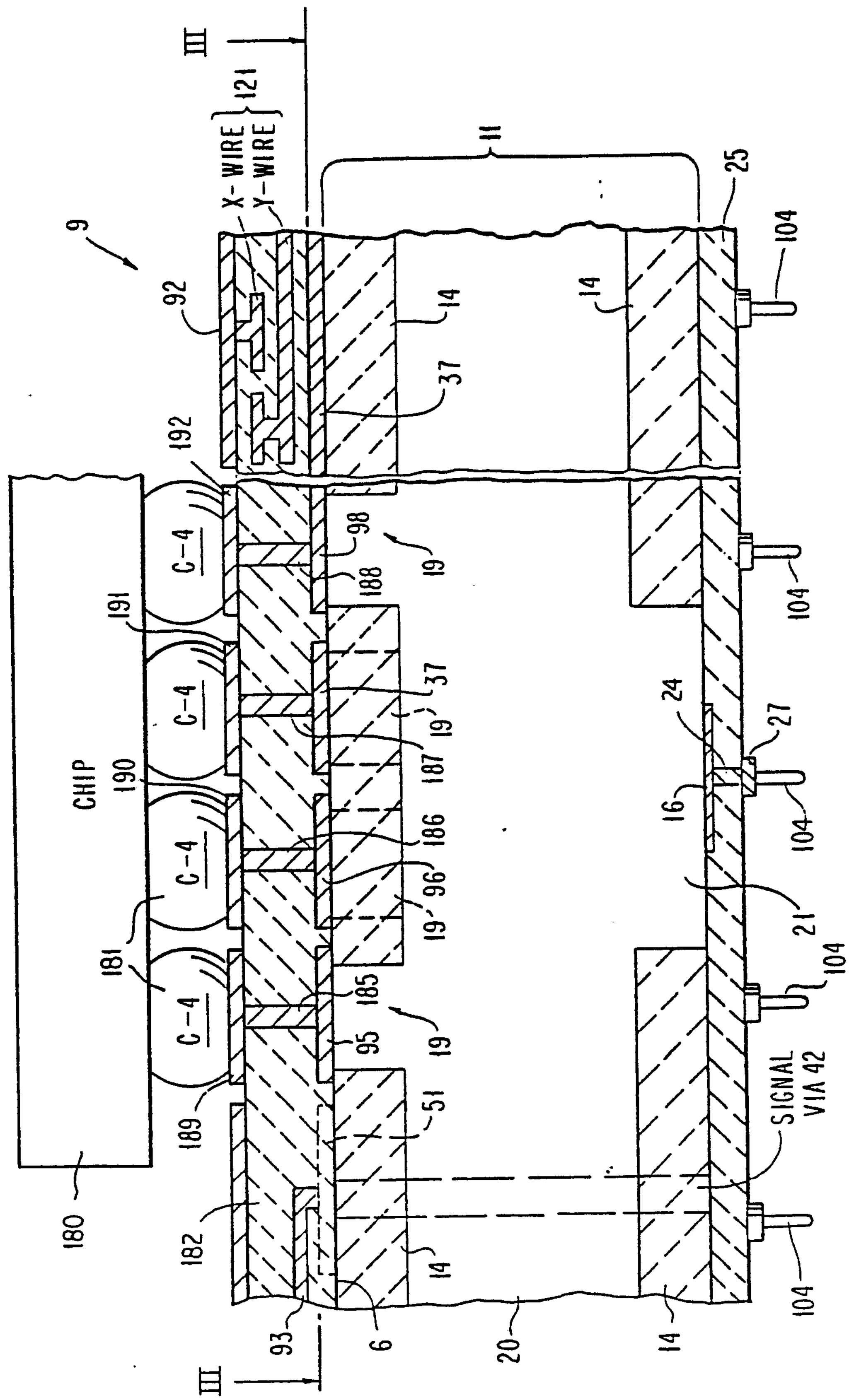
III
X-WIRE
Y-WIRE
121
9
92
11
25
14
37
104
192
C-4
98
19
188
191
CHIP
190
181
180
189
182
187
186
96
185
95
51
24
27
16
21
SIGNAL VIA 42
93
6
20

FIG. 4

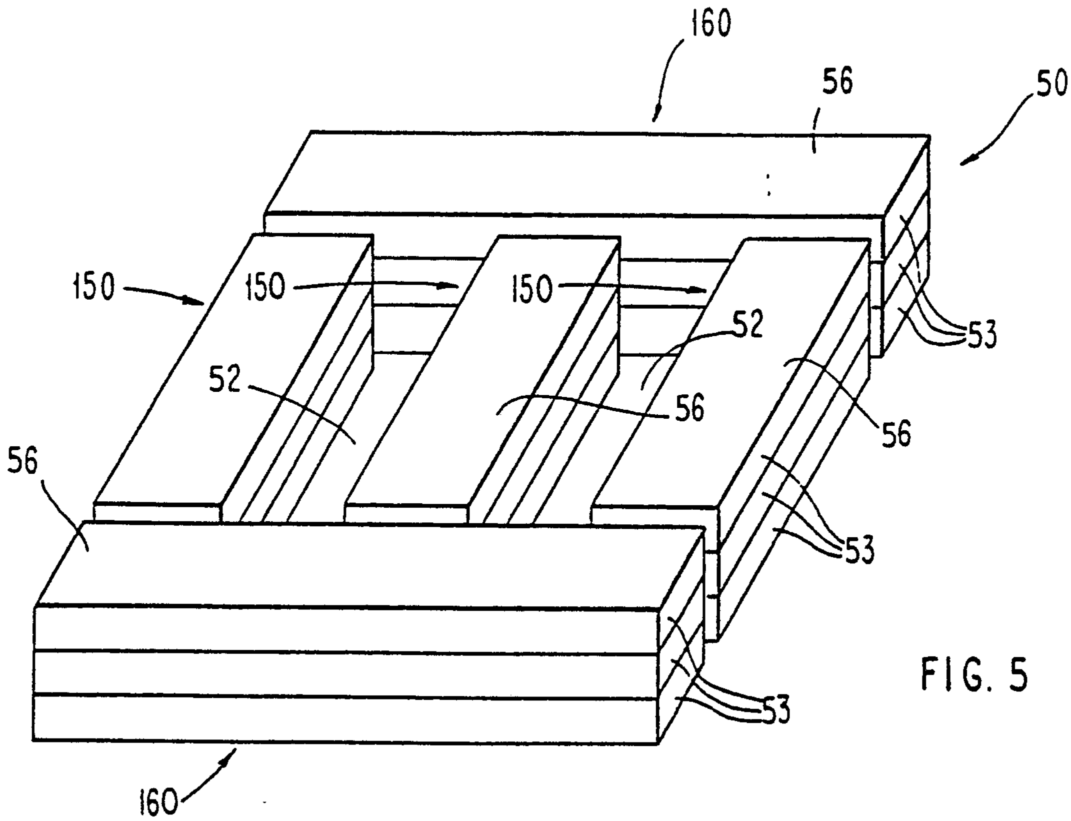
160
56
50
150
150
150
52
52
56
56
56
53
53
53
160

FIG. 5

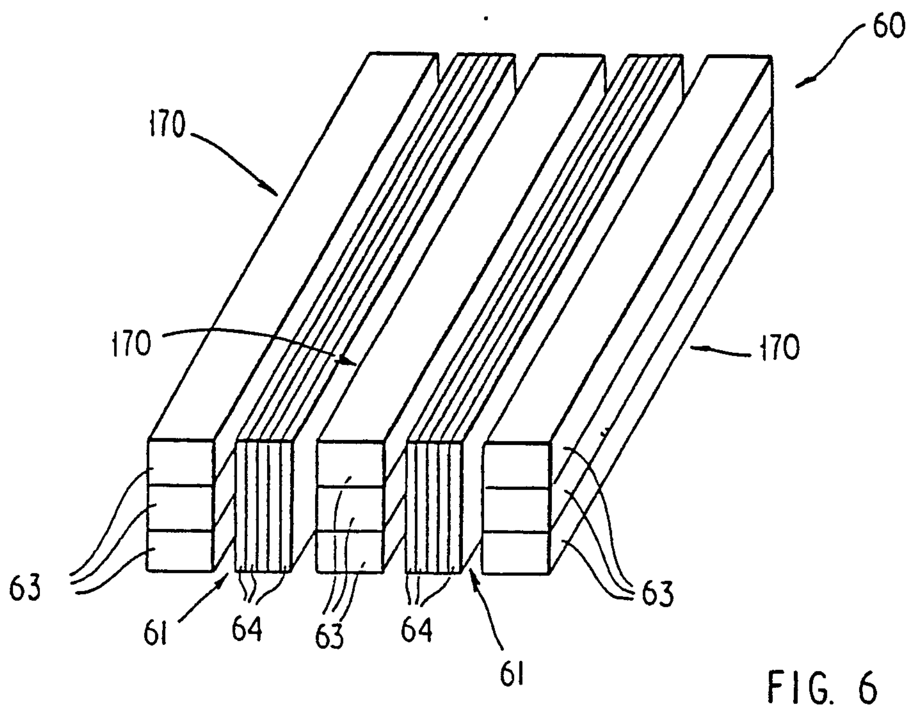
60
170
170
170
63
61
64
63
64
61
63

FIG. 6

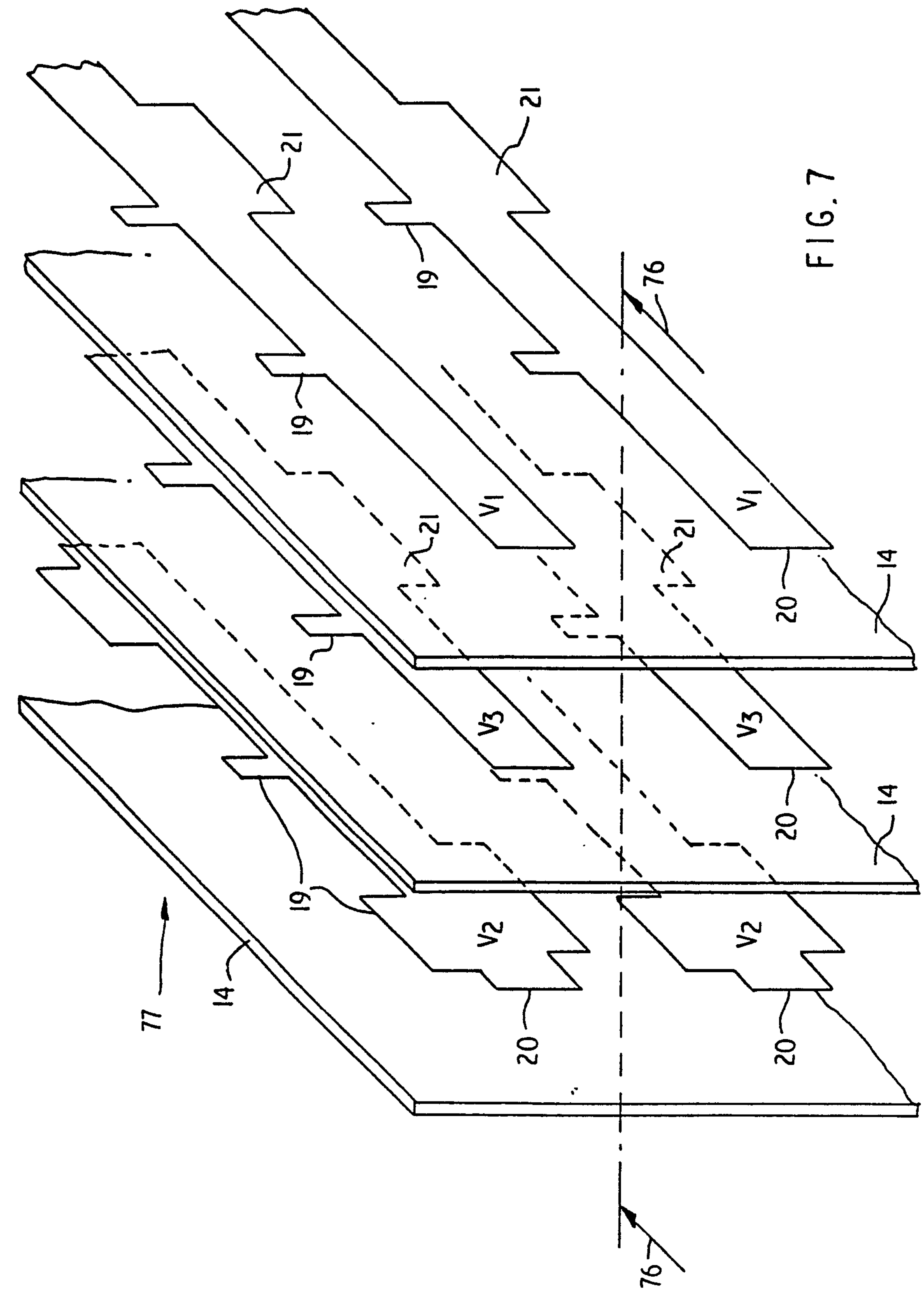


FIG. 7

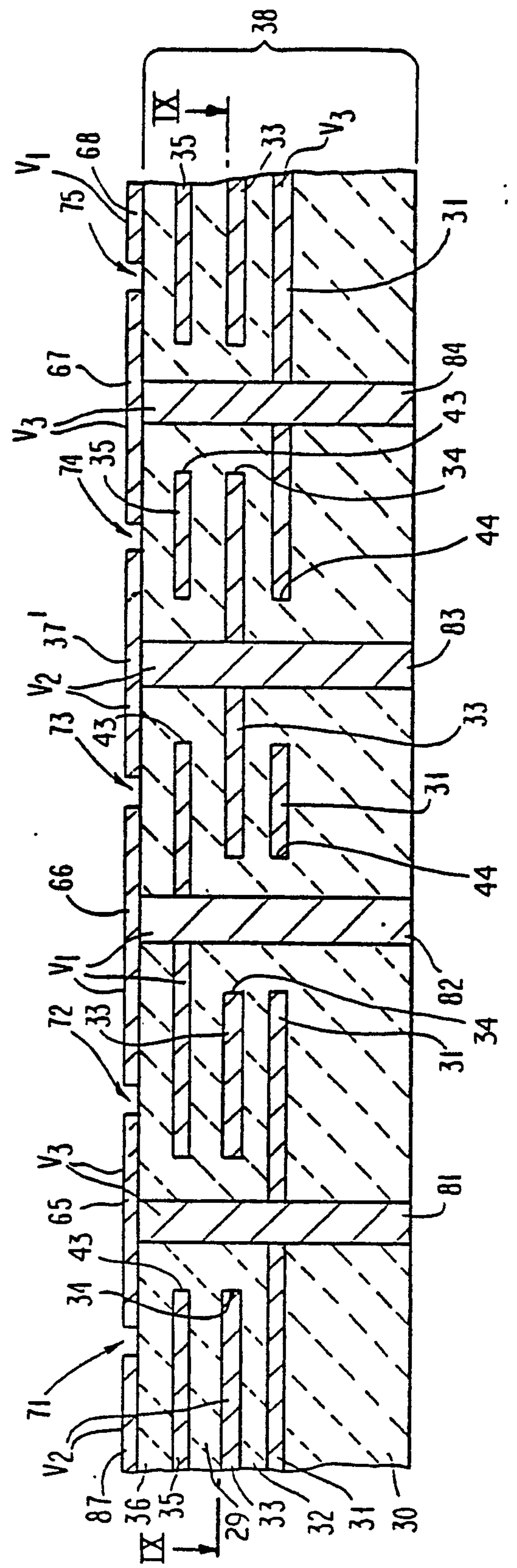

FIG. 8

FIG. 9

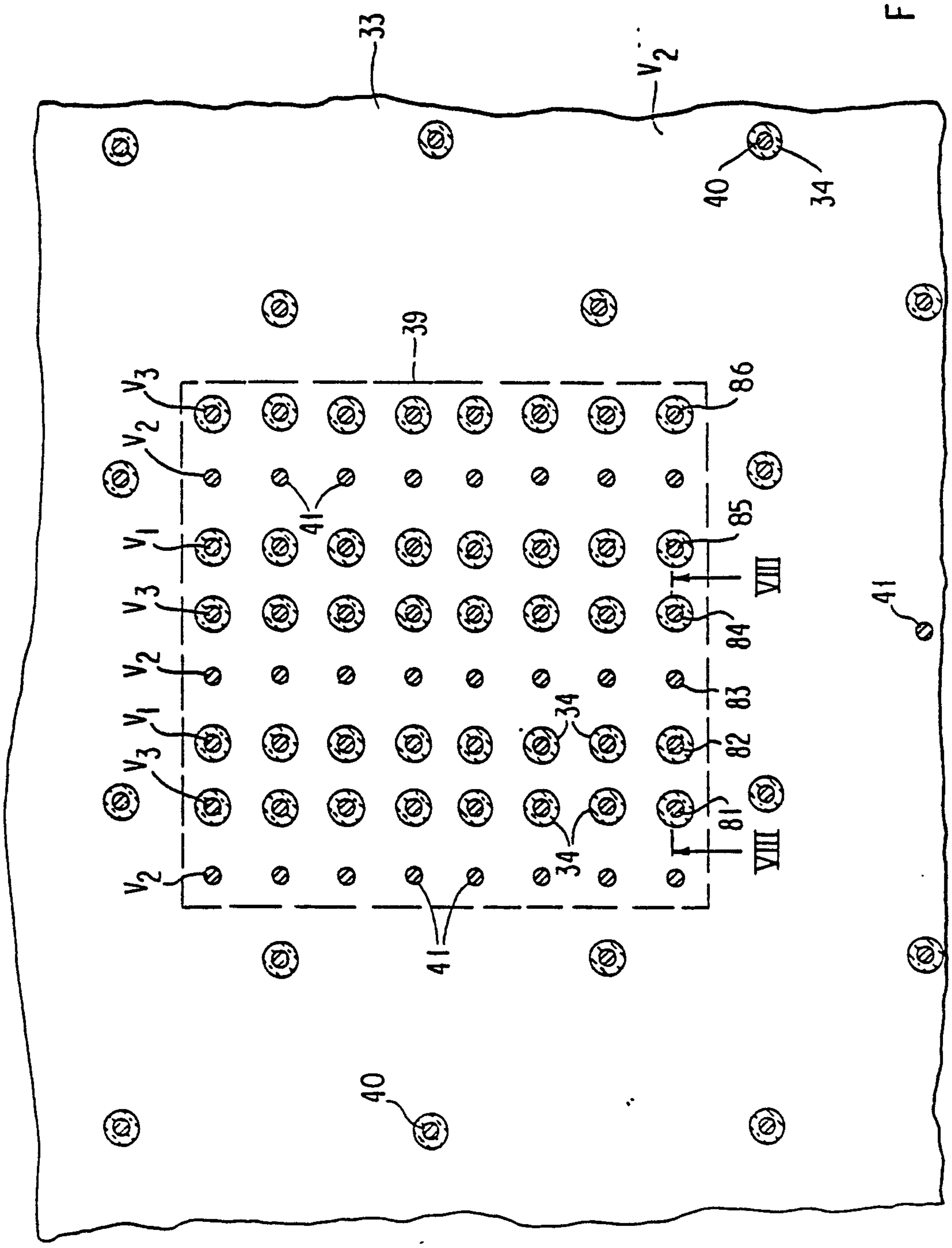

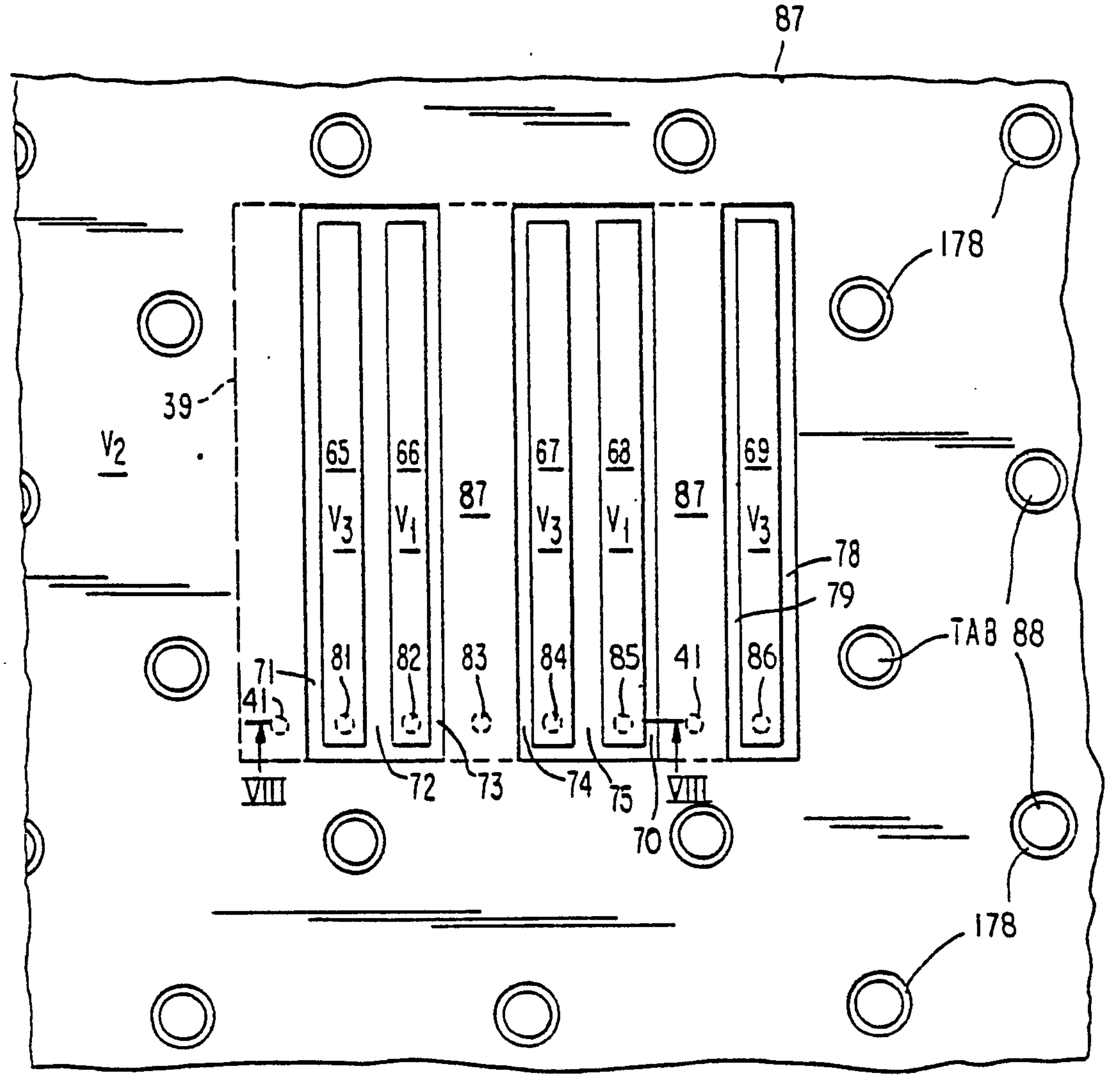
87
178
39
$V_2$
65
66
67
68
69
$V_3$
$V_1$
87
78
79
TAB 88
71
41
81
82
83
84
85
86
72
73
74
75
VIII
70
178

FIG. 10

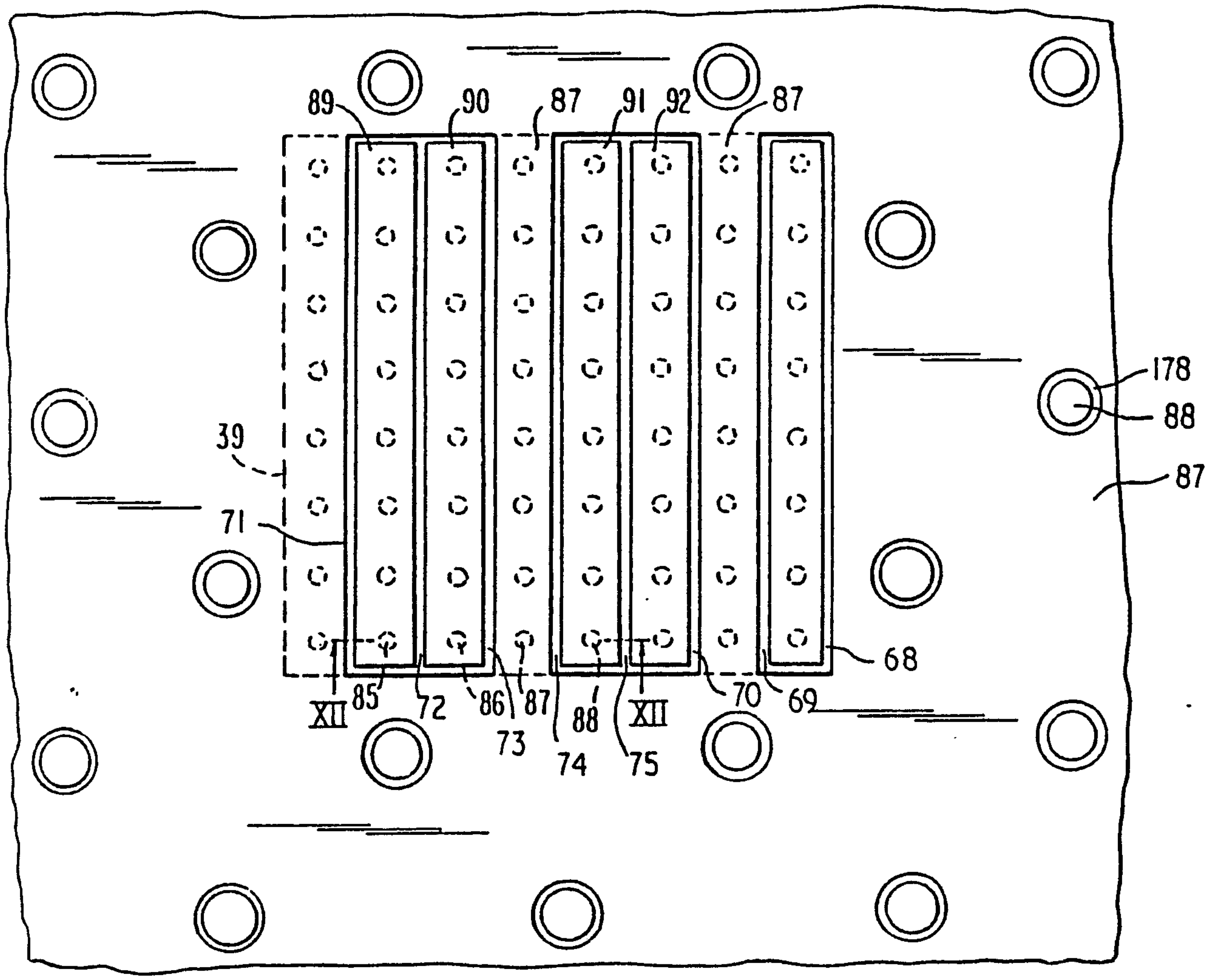
89
90
87
91
92
87
178
88
87
39
71
68
XII
85
72
86
87
73
74
88
XII
75
70
69

FIG. 11

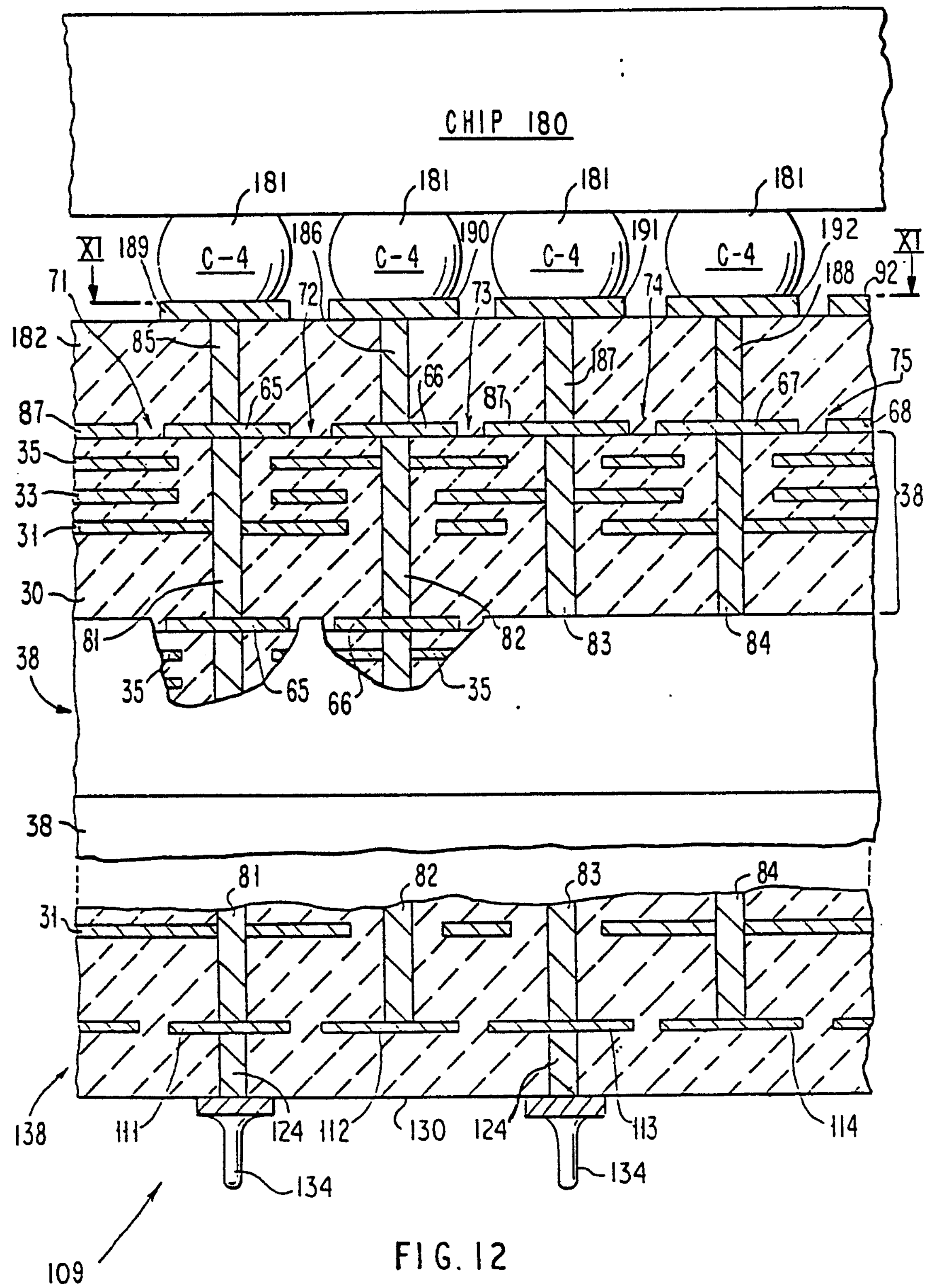
CHIP 180
181
C-4
XI
189
186
190
191
192
188
92
71
72
73
74
75
182
85
65
66
187
67
87
68
35
33
31
30
38
81
82
83
84
66
138
111
124
112
130
113
114
134
109

FIG. 12

FIG. 13

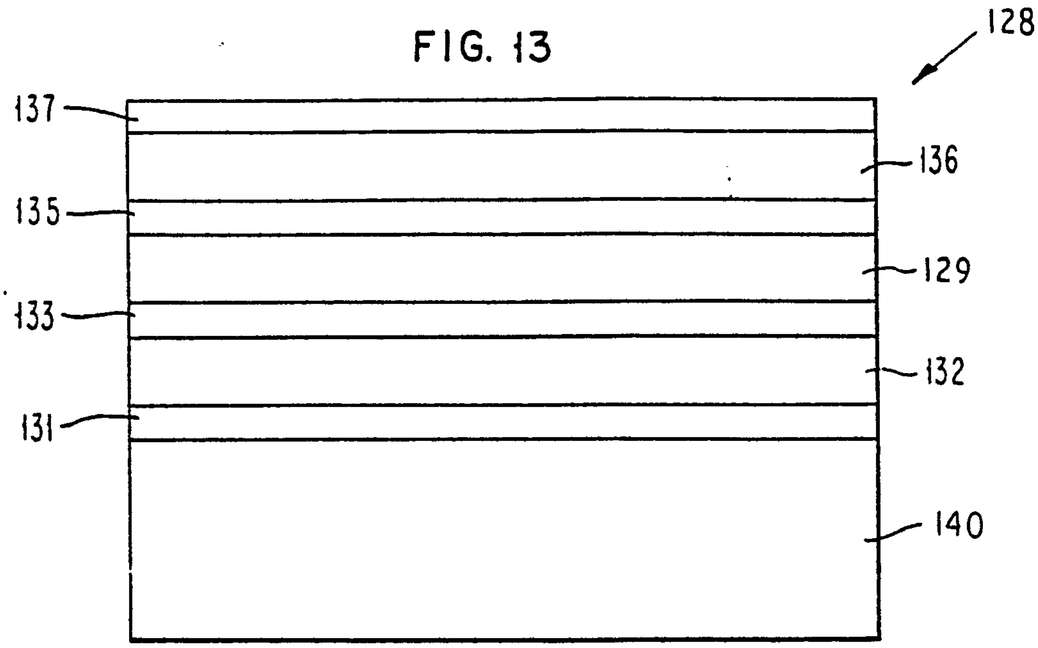
128
137
136
135
129
133
132
131
140

FIG. 14

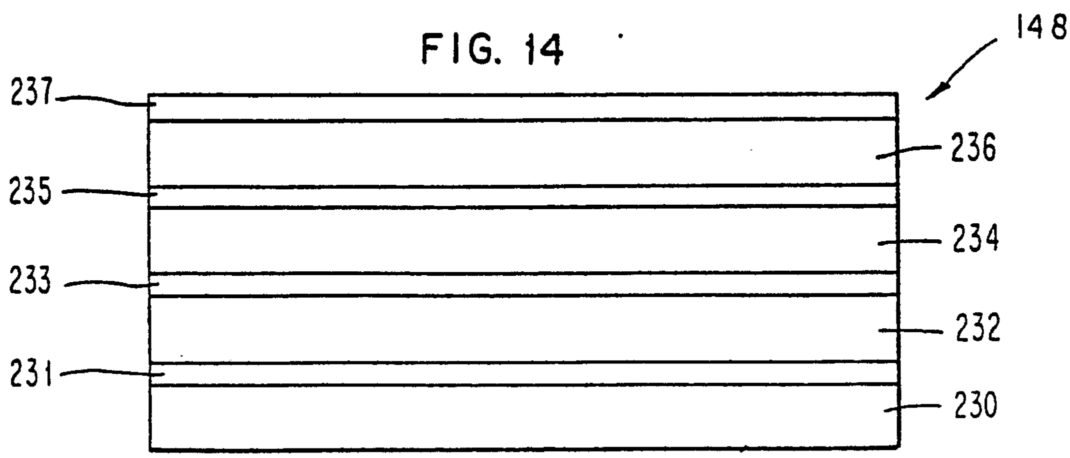
148
237
236
235
234
233
232
231
230